Europäisches Patentamt

(19) European Patent Office

Office européen des brevets

(11) Publication number: 0 359 562
A2

# (12) EUROPEAN PATENT APPLICATION

(21) Application number: 89309329.4

(22) Date of filing: 14.09.89

(51) Int. Cl.⁵: C 09 J 151/04
C 08 F 265/04, H 05 K 3/38
//(C08F265/04,220:12,220:20)

(30) Priority: 16.09.88 US 245430

(43) Date of publication of application:
21.03.90 Bulletin 90/12

(84) Designated Contracting States:
AT BE CH DE ES FR GB GR IT LI LU NL SE

(71) Applicant: ROHM AND HAAS COMPANY
Independence Mall West
Philadelphia Pennsylvania 19105 (US)

(72) Inventor: Chao, Yen-Yau Harrison
1964 Bishopwood Blvd.
Harleysville Pennsylvania 19438 (US)

Smart, Reginald T.
5 Woodview Court
Horsham Pennsylvania 19044 (US)

Will, Albert Steven
180 Eaton Court
Langhorne Pennsylvania 19047 (US)

(74) Representative: Tanner, James Percival et al
ROHM AND HAAS (UK) LTD. European Operations Patent
Department Lennig House 2 Masons Avenue
Croydon CR9 3JS (GB)

(54) Fabrication of flexible electronic circuitry using a modified latex polymer laminating adhesive composition.

(57) A modified latex polymer adhesive composition for use in the fabrication of flexible electronic circuitry is made by

(a) preparing by emulsion polymerization an initial aqueous dispersion of an initial water-insoluble latex polymer of at least one ethylenically unsaturated monomer which comprises 0 to 2% by weight of multi-alpha, beta-ethylenically unsaturated monomer, the initial latex polymer containing essentially no other sites of ethylenic unsaturation,

(b) dispersing in said initial aqueous dispersion of initial water-insoluble latex polymer additional ethylenically unsaturated monomer comprising at least one monomer having at least two sites of alpha, beta-ethylenic unsaturation, whereby said additional monomer swells said initial latex polymer, and

(c) polymerizing said additional monomer within said monomer swollen initial latex polymer to form said modified water-insoluble latex polymer.

EP 0 359 562 A2

**Description**

# FABRICATION OF FLEXIBLE ELECTRONIC CIRCUITRY USING A MODIFIED LATEX POLYMER LAMINATING ADHESIVE COMPOSITION

This invention is concerned with the use of a modified latex polymer adhesive composition in the fabrication of flexible electronic circuitry. In fabricating flexible electronic circuitry, typically a metallic foil suh as copper is adhered onto a polymeric film such as polyimide film.

Most of the pressure sensitive and contact adhesives have their glass transition temperatures below ambient. The "soft" nature of these adhesives provides effective chain diffusion and good film formation of the polymers and ensures good adhesive bond formation. However, the low glass transition temperature (Tg) of these polymers often causes the adhesive bond to excessively soften at high temperatures, which results in polymer flow, leading to low adhesive peel and shear strengths. The high temperture performance of the adhesive may be improved by increasing the Tg of the polymer or by incorporating chemical crosslinking before film formation. However, both methods put restrictions on polymer chain diffusion and reduce good film formation and adhesion. The polymeric adhesives can also be crosslinked after film formation.

High temperature performance of the adhesive is very important in many aerospace and electronic applications. In assembling high temperature (>260°C) resistant flexible printed circit boards many crosslinkable, two-part adhesives have been suggested. A water-based emulsion polymer formulated with a crosslinking melamine (or phenol)/formaldehyde additive, as well as the free-standing films isolated from this formulation are described in U.S.-A-3,900,662; U.S.-A- 3,728,150 and U.S.-A- 3,822,175.

Further, JP-A-59-81371 discloses a solvent-based adhesive composition for polyimide insulating tape which contains a crosslinking system: it comprises a non acidic, polyfunctional compound (such as diacrylic acid diester) and an organic peroxide.

EP-A-0187505 discloses modified latex polymer compositions for use in coatings, caulks, sealants and general adhesive applications. However, it does not teach or suggest that such modified latex polymer compositions are useful as a laminating adhesive in fabrication of flexible electronic circuitry and the improvements resulting therefrom.

The present invention enables disadvantages associated with prior art adhesives used in making flexible electronic circuitry to be overcome by the use of a latex that has been toughened without the necessity for an external crosslinking agent and which may be regarded as a 'single-package' latex.

This invention provides a process for making flexible electronic circuitry, comprising the use as a laminating adhesive of an aqueous dispersion of a water-insoluble latex polymer, wherein said polymer is prepared by the process comprising:

(a) preparing by emulsion polymerization an initial aqueous dispersion of an initial water-insoluble latex polymer of at least one ethylenically unsaturated monomer, wherein said ethylenically unsaturated monomer comprises no more than two percent by weight, based on the total weight of said ethylenically unsaturated monomer, of multi-alpha, beta -ethylenically unsaturated monomer and wherein said initial water-soluble latex polymer otherwise contains essentially no sites of ethylenic unsaturation,

(b) dispersing in said initial aqueous dispersion of initial water-insoluble latex polymer additional ethylenically unsaturated monomer comprising at least one monomer having at least two sites of alpha, beta -ethylenic unsaturation, whereby said additional monomer swells said initial latex polymer, and

(c) polymerizing said additional monomer within said monomer-swollen initial latex polymer.

Optionally, polymerization of the additional monomer is not begun until after the additional monomer has been permitted to swell the initial latex polymer essentially to equilibrium.

Preferably, the polymer contains, as one of said ethylenically unsaturated monomers, an acryloxycarboxylic acid monomer.

The preparation of aqueous dispersions of water-insoluble latex polymer by emulsion polymerization for use in coatings applications is well known in the art. The practice of emulsion polymerization is discussed in detail in D.C. Blackley, Emulsion Polymerization (Wiley, 1975). Conventional emulsion polymerization techniques may be used to prepare the initial aqueous dispersion of water-insoluble latex polymer of this invention. The practice of emulsion polymerization is also discussed in H. Warson, The Applications of Synthetic Resin Emulsions, Chapter 2 (Ernest Benn Ltd., London 1972).

The polymerization process may be a thermal or redox type; that is, free radicals may be generated solely by the thermal dissociation of an initiator species, or a redox system may be used. A monomer emulsion containing all or a portion of the monomers to be polymerized may be prepared using the monomers, water and emulsifiers. A catalyst solution containing catalyst in water may be separately prepared. The monomer emulsion and catalyst solution may be cofed into the polymerization vessel over the course of the emulsion polymerization. The reaction vessel itself may initially contain water, and may additionally contain seed emulsion and further may additionally contain an initial charge of polymerization catalyst. The temperature of the reaction vessel during the emulsion polymerization may be controlled by cooling to remove that heat generated by the polymerization reaction or by heating the reaction vessel. Several monomer emulsions may be simultaneously cofed into the reaction vessel. When multiple monomer emulsions are cofed, they may be of different monomer composition. The sequence and rates at which the various monomer emulsions are cofed may be altered during the emulsion polymerization process. The pH of the contents of the reaction vessel may also be altered during the course of the emulsion polymerization process.

The initial latex polymer preferably comprises about 70 to about 95% by weight of the total solid latex polymer. Preferably, the initial latex polymer has a glass transition temperature from about 0 to about 40°C.

The monomer used in preparing the initial aqueous disperison of latex polymer may be any of those conventionally used in the synthetic emulsion polymerization art. Examples of suitable acrylic monomers include the ($C_1$-$C_{24}$) alkyl esters of acrylic and methacrylic acids. Examples of ($C_1$-$C_{24}$) alkyl groups of esters of acrylic and methacrylic acids which may be used in forming the initial latex polymer used in the invention include: methyl, propyl, isopropyl, butyl, isobutyl, sec -butyl, t-butyl, amyl, isoamyl, t-amyl, hexyl, cyclohexyl, 2-ethylhexyl, octyl, decyl, lauryl, myristyl, cetyl and stearyl groups. Specific examples of such esters include: methyl methacrylate, ethyl acrylate, n-butyl acrylate, 2-ethylhexyl acrylate, lauryl methacrylate, isodecyl methacrylate, methyl acrylate, ethyl methacrylate, sec -butyl acrylate and t-butyl methacrylate. The ($C_1$-$C_{12}$) alkyl esters of acrylic and methacrylic acid are preferred in preparing the initial latex polymer.

While alkyl acrylates and methacrylates are preferred, other monoethylenically unsaturated polymerizable monomers useful (preferably at an amount less than 50% by weight of the total monomer composition) as comonomers with acrylic monomers in preparing the initial latex polymer of this invention include the vinylidene halides, vinyl halides, methacrylonitrile, vinyl esters such as vinyl formate, vinyl acetate and vinyl propionate, and mixtures of ethylene and such vinyl esters, acrylic and methacrylic acid esters of alcohol ethers such as diethylene glycol monoethyl or monobutyl ether methacrylate, ($C_1$-$C_{10}$) alkyl esters of beta -acryloxypropionic acid and high oligomers of acrylic acid, styrene and alkyl substituted styrenes and vinyl aromatics including alpha-methyl styrene, mixtures of ethylene and other alkyl-olefins such as propylene, butene and pentene and vinyl ethers such as methyl vinyl ether, ethyl vinyl ether, vinyl 2-methoxyethyl ether and vinyl 2-chloroethyl ether.

Additional monoethylenically unsaturated polymerizable comonomers useful in preparing the initial latex polymer of this invention include hydroxy functional vinyl monomers such as 2-hydroxyethyl methacrylate, 2-hydroxyethyl acrylate, 3-hydroxypropyl methacrylate, butanediol acrylate, 3-chloro-2-hydroxypropyl acrylate, 2-hydroxypropyl acrylate, and 2-hydroxypropyl methacrylate. Further examples of useful monomers include the partial esters of unsaturated aliphatic dicarboxylic acids and particularly the alkyl half esters of such acids. Examples of such partial esters are the alkyl half esters of itaconic acid, fumaric acid and maleic acid wherein the alkyl group contains 1 to 6 carbon atoms. Representative members of this group of compounds include methyl acid itaconate, butyl acid itaconate, ethyl acid fumarate, butyl acid fumarate, and methyl acid maleate. Minor amounts of other comonomers, such as adhesion promoting comonomers, may also be used. These monomers may be copolymerized with acrylic monomers to yield the initial aqueous dispersion of latex polymer.

Examples of alpha, beta-ethylenically unsaturated carboxylic acids which may be copolymerized with acrylic and other monomers in forming the initial latex polymer of the invention include acrylic acid, methacrylic acid, acryloxycarboxylic acid and higher oligomers of acrylic acid and mixtures thereof, ethacrylic acid, itaconic acid, aconitic acid, crotonic acid, citraconic acid, maleic acid, fumaric acid, alpha-chloracrylic acid, cinnamic acid, mesaconic acid and mixtures thereof. Acrylic and methacrylic acids are preferred, and methacrylic acid is especially preferred. It is preferred that alpha, beta -ethylenically unsaturated carboxylic acid comprise from about 0.5 to 5 percent by weight based on the total weight of monomer, of the initial latex polymer monomer composition. The most preferred composition contains acryloxycarboxylic acid such as described in U.S.-A-3,266,930.

In addition to monoethylenically unsaturated monomer, small proportions of alpha, beta-ethylenic unsaturated monomer having at least two sites of alpha, beta-ethylenic unsaturation, that is, multi-ethylenically unsaturated monomer, may be used as comonomer in preparing the initial latex polymer. However, it is not necessary to employ any multi-ethylenically unsaturated monomer. For example, allyl methacrylate or divinyl benzene may be used. Allyl methacrylate is preferred. The initial latex polymer may be prepared from a monomer mixture containing from about 0.005 to 2 percent by weight, based on the weight of the total solids of the initial polymer, of monomer containing at least two sites of alpha, beta -ethylenic unsaturation.

Even in those cases in which no di- or multi-ethylenically unsaturated monomer is used as comonomer in preparing the initial latex polymer, as is well known in the art, a small proportion of monomer may remain unreacted, or the free radical polymerization of individual polymer chains may terminate with disproportionation, polymerization may be incomplete, or other processes may occur which result in the inclusion of a small proportion of sites which are ethylenically unsaturated within the otherwise saturated polymer chain. Polymer which contains such incidental sites of unsaturation is referred to as containing essentially no sites of ethylenic unsaturation in the present specification and claims.

In one embodiment, it is preferred that the initial latex polymer be prepared by emulsion polymerization of alpha, beta-ethylenically unsaturated monomer comprising

(a) from about 60 to 84 parts by weight, based on the total solid weight of the initial latex polymer, of monomer being either ($C_1$-$C_{12}$) alkyl esters of acrylic acid, more preferably, butyl acrylate, the ($C_1$-$C_{12}$) alkyl esters of methacrylic acid, or mixtures thereof, and

(b) from about 0.1 to 6.0 parts by weight, based on the total weight of solids of the initial latex polymer, of carboxylic acid monomer being either acrylic acid, methacrylic acid, itaconic acid, beta-acryloxypropionic acid or the higher oligomers of acrylic acid or mixtures thereof (more preferably 1.0 to 2.5 parts acrylic acid or 4 to 6 parts acryloxypropionic acid); and

(c) from about 15 to 40 parts (more preferably 22 to 30 parts) acrylonitrile.

After preparation of the initial aqueous dispersion of latex polymer, the second step in the process of preparing the compositions of this invention may be undertaken. In the second step of this process, additional alpha, beta-ethylenically unsaturated monomer comprising at least one monomer having at least two sites of alpha, beta -ethylenic unsaturation, wherein said additional monomer preferably has low water-solubility, is dispersed in the initial aqueous dispersion of water insoluble latex polymer. Examples of alpha, beta-ethylenically unsaturated monomer having at least two sites of alpha, beta-ethylenic unsaturation include ethyleneglycol dimethacrylate, diethyleneglycol dimethacrylate, triethyleneglycol dimethacrylate, polyethylene glycol dimethacrylate, polypropyleneglycol dimethacrylate, neopentylglycol dimethacrylate, 1,3-butyleneglycol diacrylate, neopentylglycol diacrylate, trimethylolethane trimethacrylate, dipentaerythritol triacrylate, dipentaerythritol tetraacrylate, dipentaerythritol pentaacrylate, dimethallyl chlorendate, diallyl chlorendate, diallyl fumarate, diallyl itaconate, diallyl phthalate, diallyl-isophthalate, triallyl trimellitate, 1,6-hexenediol diacrylate, 1,3-butylene glycol dimethacrylate, trimethylolpropane trimethacrylate, trimethylol propane triacrylate, tripropylene glycol diacrylate, diallyl methacrylate, and divinyl benzene.

It is preferred that the additional alpha, beta -ethylenically unsaturated monomer comprise about 25 percent to 100% by weight, based on the total weight of additional alpha, beta-ethylenically unsaturated monomer, of monomer having at least two sites of alpha, beta -ethylenic unsaturation.

It is preferred that monomer having at least two sites of alpha, beta-ethylenic unsaturation be selected from the group consisting of monomers having two sites of alpha, beta-ethylenic unsaturation and monomers having three sites of alpha, beta-ethylenic unsaturation. It is also preferred that monomers having two sites of alpha, beta-ethylenic unsaturation be selected from the diacrylates and dimethacrylates. It is also preferred that monomers having three sites of alpha, beta-ethylenic unsaturation be selected from the triacrylates and trimethacrylates. In another embodiment it is preferred that the monomer having two sites of alpha, beta-ethylenic unsaturation be selected from divinyl benzene and aliphatic conjugated dienes. Of the preferred diacrylates and dimethacrylates, 1,6-hexeneglycoldimethacrylate, ethyleneglycoldimethacrylate, 1,6-hexanedioldiacrylate, 1,3-butyleneglycoldimethacrylate, and tripropyleneglycoldiacrylate are especially preferred. Of the preferred triacrylates and trimethacrylates, trimethylol propane triacrylate and trimethylol propane trimethacrylate are especially preferred.

In the most preferred embodiment the additional alpha, beta-ethylenically-unsaturated monomer comprises 100% 1,3-butyleneglycol-dimethacrylate or 25% 1,3-butyleneglycoldimethacrylate and 75% methyl methacrylate or isobornyl methacrylate.

Other monomers useful as monomer having at least two sites of alpha, beta-ethylenic unsaturation include the reaction products of at least one compound selected from the diisocyanates and triisocyanates and at least one compound selected from hydroxy $(C_1-C_6)$ alkyl acrylates and hydroxy $(C_1-C_6)$ alkyl methacrylates. Examples of these include the reaction product 3-hydroxypropyl methacrylate and 2,4-toluene diisocyanate, and the reaction product of 3-hydroxypropyl methacrylate and 2,4-toluene diisocyanate, and the reaction product of 2-hydroxyethyl acrylate and hexamethylene diisocyanate. Similarly, the reaction products of at least one of the di- and tri-epoxy functional compounds and acrylic acid and/or methacrylic acid may be employed. In addition, the reaction products of at least one of the $di(C_1-C_4)$alkoxylated $(C_2-C_8)$ alkanediols, $tri(C_1-C_4)$alkoxylated bisphenol A, and acrylic acid and/or methacrylic acid may be employed. The reaction product of trimethylol propane and beta-acryloxypropionic acid may also be employed.

It is preferred that the ratio of the weight of solids of the polymerized additional alpha, beta-ethylenically unsaturated monomer to the weight of solids of the initial latex polymer be from about 1:100 to 1:10. It is more preferred that this ratio be from about 1:20 to 1:10.

Alpha, beta-ethylenically unsaturated monomer having at least two sites of alpha, beta-ethylenic unsaturation may be referred to as "multifunctional monomer" (MFM). In addition to the multifunctional monomer which may be added to the initial latex polymer during the second step of the process of preparing the compositions of this invention, mono-ethylenically unsaturated monomer may also be employed in this second step with said multifunctional monomer. This may be accomplished by preparing a mixture of mono-ethylenically unsaturated monomer and multifunctional monomer and adding this mixture to the initial aqueous dispersion of water-insoluble latex polymer. Alternatively, multifunctional monomer and monoethylenically unsaturated monomer may be added separately to the initial aqueous dispersion. Examples of mono-ethylenically unsaturated monomer which may be employed include the $(C_1-C_{12})$alkyl esters of acrylic acid, the $(C_1-C_{12})$alkyl esters methacrylic acid, and isobornyl methacrylate. It is preferred that the mono-ethylenically unsaturated monomer employed in this step be one of methyl methacrylate, butyl methacrylate, butyl acrylate or isobornyl methacrylate. It is preferred that no more than about 75% by weight of the additional alpha, beta-ethylenically unsaturated monomer be mono-ethylenically unsaturated monomer.

The additional monomer used to swell said initial latex polymer may optionally contain from 0 to about 3% by weight of carboxylic acid monomers mentioned earlier.

Preferably the additional monomer comprises about 5 to about 30% by weight of the final latex polymer on a solids basis.

The additional monomer which is used should be selected such that the additional monomer comprises a substantial proportion of monomer which has low water solubility. Monomers with low water solubility will be preferentially distributed into the hydrophobic phase of the aqueous dispersion, that is, into the water-insoluble latex polymer, wherein such monomers may be subsequently polymerized. Thus, it is desirable

EP 0 359 562 A2

to employ monomer with low water solubility as additional monomer. Low levels, e.g. less than about 5 weight percent, of water soluble monomers such as ethylenically unsaturated carboxylic acids such as methacrylic acid or acrylic acid may be included in the additional monomer. As the proportion of a monomer included in the additional monomer charge increases, it must be increasingly hydrophobic. Additional monomer containing largely butyl acrylate, ethyl acrylate, methyl methacrylate or a blend thereof, is sufficiently hydrophobic to be used (water solubility about 0.20 g., 1.5 g., and 1.7 g./100 g. water, respectively). A range of monomers which vary widely in hydrophilic/hydrophobic character may be used in the additional monomer blend as long as the hydrophobic/hydrophilic character of the additional monomer blend is balanced so that the additional monomer is polymerized mainly within the first stage polymer rather than in the aqueous phase.

After the additional ethylenically unsaturated monomer is added to the initial aqueous dispersion of latex polymer, sufficient time is allowed to permit the additional monomer to swell the latex particles. The additional monomer is preferably selected to include only those monomers which have low water solubility. By low water-solubility is meant a solubility in water at ambient temperature of less than about 2 g./100 g. of water (2 wt. %). Preferably, the additional monomer is allowed to swell the initial latex polymer until the monomer swollen initial latex polymer has been swollen essentially to equilibrium with the additional alpha, beta-ethylenically unsaturated monomer. The aqueous dispersion may be agitated during the swelling process.

After the initial aqueous dispersion of latex polymer has been swollen, e.g. essentially to equilibrum, the additional monomer is polymerized within the monomer swollen initial latex polymer. This second polymerization may be initiated by conventional free radical generating initiator systems. Conventional sources of free radicals such as organic peroxides, hydroperoxides, peresters, and persulfate may be employed. Initiating free radicals may be obtained from redox initiator systems. Typical redox initiating systems which may be employed include t-butyl peroxide/Fe(II), t-butyl hydroperoxide-/sodium formaldehyde sulfoxylate/Fe(II), t-butyl hydroperoxide/-isoascorbic acid, ammonium persulfate/sodium metabisulfite, and t-butyl hydroperoxide/vanadyl sulfate. The t-butyl hydroperoxide/vanadyl sulfate redox system is preferred. In addition to redox initiator systems, free radicals may be obtained from the thermal dissociation of a free radical precursor initiator species such as ammonium persulfate, sodium persulfate, t-butylperoxy pivalate, and t-butyl hydroperoxide. The second step polymerization may be carried out at ambient temperature or at an elevated temperature.

Various optional additives may be added to the adhesive compositions of this invention at a level up to about 10% by weight based on total solid weight of latex polymer. The additives include epoxy resins, such as diglycidyl ethers of Bisphenol A or Bisphenol F, glycidyl ethers of novalac resins or alicyclic diepoxy carboxylate. A reactive surfactant having epoxide functionality may be used to emulsify the epoxy. Catalysts and curing agents may also be added such as the following:

1. Difunctional amine-terminated polypropylene glycols with an average molecular weight between 200 and 2000;

2. Trifunctional amine-terminated polypropylene glycols with an average molecular weight between 400 and 5000;

3. Polyether amines based on a predominanatly on a polyethylene oxide backbone with an average molecular weight between 600 and 2000;

4. Urea condensates of the amine-terminated polyproylene glycols used to increase the average molecular weight of amine;

5. Any mixtures of the above amines;

6. Nitrogen-containing curing agents such as urea, ethylene urea, phenylene diamine, malonamide, propionamide, dicyandiamide, tetrabutyl ammonium hydroxide, dimethyl amino ethanol, and triethanol amine;

7. Polyamide curing agents which are polymeric amido-amines with both amine and amide functionality; and

8. Inorganic bases such as sodium hydroxide.

Other additives may be melamine formaldehyde crosslinking agents; phenol formaldehyde crosslinking agents; curing agents based on the reaction of dialcohol amines and difunctional acids or adipates; plasticizers such as dioctyl phthalate or butyl benzyl phthalate; tackifiers; or fillers such as silica, glass fibers or calcium carbonate.

The laminating adhesive of this invention is useful in the fabrication of a variety of flexible electronic circuitry. The adhesive may be used to attach a metallic foil such as copper, iron, nickel, aluminum, silver, gold and the like to a variety of substrates, such as for example, polyimide, polyester, epoxy-reinforced polyester fibers, epoxy-modified glass fibers, polyvinyl fluoride, polyethylene, polypropylene or aramid paper. The adhesive is also useful in bonding the substrates together.

The adhesive composition of this invention can be applied to the substrate by conventional application procedures such as spraying, dipping, brushing, or roll coating either in a batch lamination or a continuous lamination process. The adhesive can be applied in varying thickness, preferably at a thickness of about 0.1 to about 2 mils (2.5 to 51 μm).

The laminating adhesive of this invention is useful in many flexible electronic circuitry applications, such as fabrication of circuit boards, switches, structural members, electrical tape and the like. The preferred laminating adhesive is a one-pot waterborne modified emulsion polymer-adhesive which results in improved

5

peel strength, adhesion, heat resistance and solder resistance and has low moisture absorption.

The following examples are presented to demonstrate this invention. The examples are intended to be illustrative, but not limitative. All parts and percentages are on a weight basis unless otherwise indicated.

The following abbreviations are used in the examples:

BA = butyl acrylate
AN = acrylonitrile
MAA = methacrylic acid
t-BHP = t-butyl hydroperoxide
SSF = sodium sulfoxylate formaldehyde
BGDMA = 1,3-butylene glycol dimethacrylate
AOPA = acryloxypropionic acid
HPMA = hydroxypropyl methacrylate
HEMA = hydroxyethyl methacrylate
PEMA = phosphoethyl methacrylate acid
AOG = acryloxyglycine

## EXAMPLE I

Following conventional emulsion polymerization techniques an initial latex polymer comprising 85BA/12AN/3MAA was prepared via a thermal gradual addition process at 80°C. To a 5-liter, 4-neck flask equipped with a condenser, thermomemter, stirrer, and inlets for monomer emulsion and catalyst co-feeds, was charged 600g of distilled water and 0.5g sodium carbonate. A pre-mixed monomer emulsion as described below was prepared.

| Quantity | Material |
|---|---|
| 21.6 g | sodium dodecyl benzene sulfonate (Siponate DS-4) |
| 1658 g | Butyl Acrylate |
| 234 g | Acrylonitrile |
| 58.5 g | Methacrylic acid |
| 525 g | distilled water |
| 75 g | rinse, distilled water |

After pre-heating the vessel to 85°C, 6.14 g sodium persulfate were added. The monomer emulsion given above and a sodium persulfate co-feed (2.63g/ 125 water) were added over 3 hours at 80°C. After a 1/2-hour hold period, the reaction temperature was lowered to 60°C and chased with a conventional t-butyl hydroperoxide/sodium sulfoxylate formaldehyde redox couple.

The final properties of the initial latex polymer are as follows:

pH = 2.9
Particle Size = 321 nanometers
Solids = 56.1%
Viscosity (#2/60 rpm) = 122.5 X $10^{-3}$ Pa s (122.5 centipoise)

## Example II

To 1000g. of the initial polymer composition from Example I were added 56.1 g. 1,3-butylene glycol dimethacrylate (Rocryl-970 from Rohm and Haas Co.). It was allowed to swell the initial latex polymer at 45°C and then a t-BHP/SSF redox couple was used to initiate the polymerization. A modified latex polymer composition within the scope of this invention resulted.

## Example III

To 1000g. of the initial latex polymer composition from Example I were added 28.5 g. 1,3-butylene glycol dimethacrylate (Rocryl-970). It was allowed to swell the initial latex polymer at 45°C and then a t-BHP/SSF redox couple was used to initiate the polymerization. A modified latex polymer composition within the scope of this invention resulted.

## Example IV

Following the procedure described in Example I, an initial latex polymer was prepared having the composition 72 BA/22AN/6AOPA. The resultant initial latex polymer had the following final properties:
pH = 2.9
Particle Size = 262 nanometers
Solids = 52.8%
Viscosity(#2/60 rpm) = 15 X 10⁻³ Pa s (15 centipoise)

To 750 g. of the initial latex polymer composition described above was added 19.8 g. BGDMA (Rocryl-970). It was allowed to swell the initial latex polymer at 60°C and then a t-BHP/SSF redox couple was used to initiate the polymerization. A modified polymer composition within the scope of this invention resulted.

Example V

A 1-mil (25 µm) thickness polyimide film was coated with the modified latex polymer composition (50% solids) prepared in Example IV. The polymer composition was coated on the polyimide film at a 2-mil (51 µm) thickness and then dried in a 240°F (116°C) oven for 10 minutes.

The coated polyimide film was then laminated to the dull side of copper foil containing one ounce of copper per square foot (0.304 kg/m²). The laminate was then subjected to a pressure of 150 pounds per square inch (1.035 M Pa) and a temperature of 300°F (149°C) for 30 minutes in a heated press. The resulting laminate was useful to manufacture flexible circuit boards.

Example VI

Following the procedure of Example V, laminates were made using the initial latex polymer composition from Example I and the modified latex polymer composition from Example II, respectively.

Both laminates were tested for heat stability by placing a 6.45 square centimetre (1 square-inch) sample (with copper side facing down) on the surface of a solder bath for 10 seconds at 260°C. The laminate prepared using the polymer composition from Example I failed this test by the formation of blisters, while the laminate prepared using the modified latex polymer composition from Example II passed with no formation of blisters.

The above test was repeated after increasing the temperature of the solder bath to 288°C. The laminate prepared using the polymer composition from Example I failed, while the laminate prepared using the polymer composition from Example II passed.

Example VII

Following the procedures of Example V, laminates were prepared using the modified latex polymer composition prepared in Example III and Example IV. Each laminate was cut into a 1-inch (25 mm) by 6-inch (152 mm) strip and tested for peel strength. The peel strength test was conducted on a Tensile Tester at a crosshead speed of 0.2 inch per minute (5.1 mm/min) and at a 90-degree angle. The laminate prepared with the modified latex polymer composition of Example III containing MAA had a peel strength of 6 pounds per linear inch (0.11 kg/linear mm). The laminate prepared with the modified latex polymer composition of Example IV containing AOPA had a peel strength of 8 pounds per linear inch (0.14 kg/linear mm).

Example VIII

Following the procedures of Example I and Example II, various modified latex polymer compositions within the scope of this invention were prepared having the compositions given below:

Composition (percent / parts by weight)

| Sample | Initial Latex Polymer | Additional Monomer |
|---|---|---|
| A | 95% (72 BA/22 AN/6AOPA) | 5% (15 HPMA/85 BGDMA) |
| B | 95% (73.25 BA/22 AN/4.75 HEMA) | 5% BGDMA |
| C | 95% (73.25 BA/22 AN/4.75 HEMA) | 5% (15 HPMA/85 BGDMA) |
| D | 95% (72 BA/22 AN/6 PEMA) | 5% (15 HPMA/85 BGDMA) |
| E | 95% (75 BA/22 AN/3 AOG) | 5% (15 HPMA/85 BGDMA) |

The above modified latex polymer emulsions were used to prepare adhesive compositions containing various additives according to the following formulations:

7

Adhesive formulations (grams)

| Ingredients | Sample: | 1 | 2 | 3 | 4 | 5 | 6 | 7 | 8 | 9 | 10 | 11 | 12 |
|---|---|---|---|---|---|---|---|---|---|---|---|---|---|
| Latex Emulsion (100 grams) | | A | A | A | A | A | A | A | A | A | B | C | E |
| Crosslink Agents: | | | | | | | | | | | | | |
| Epoxy[1] | | 3.0 | 6.0 | 6.0 | 3.0 | - | - | - | - | - | 6.4 | 6.4 | 3.0 |
| Epoxy[2] | | - | - | - | - | 12.1 | - | - | - | - | - | - | - |
| Epoxy[3] | | - | - | - | - | - | 3.5 | - | - | - | - | - | - |
| Epoxy[4] | | - | - | - | - | - | - | 2.4 | - | - | - | - | - |
| BGA [5] | | - | - | - | - | - | - | - | 2.25 | | | | |
| Curing Agents: | | | | | | | | | | | | | |
| polyoxyether diamine[6] | | 1.0 | - | - | - | - | - | - | - | - | - | - | 1.0 |
| aromatic sulfonic acid[7] | | - | - | - | - | - | - | - | 0.5 | - | - | - | - |
| QM552[8] | | - | - | - | - | - | - | - | - | 2.8 | - | - | - |
| dimethylaminoethanol | | - | 0.3 | - | - | - | - | - | - | - | - | - | - |
| ethylene diamine | | - | - | 0.1 | - | - | - | - | - | - | - | - | - |
| ethylene urea | | - | - | - | - | - | - | 0.6 | - | - | - | - | - |
| dicyandiamide | | - | - | - | - | 0.25 | - | - | - | - | - | - | - |
| Fumed silica | | - | - | - | 2.0 | - | - | - | - | - | - | - | - |

[1] Aqueous emulsion of diglycidylether of Bisphenol A (eq. wt. 200)
[2] non-ionic aq. dispersion of diglycidyl ether of Bisphenol A (eq. wt. 700)
[3] non-ionic aq. dispersion of novalac epoxy resin (eq. wt. 205)
[4] liquid cycloaliphatic epoxy resin (eq. wt. 137)
[5] methylated/ethylated benzguanamine
[6] Jeffamine D400 (40%) from Texaco Chemical Co.
[7] Aerotex 4040 (40%) from American Cyanamid Co.
[8] Reaction product of diethanol amine and adipic acid.

EP 0 359 562 A2

The adhesive formulations above were evaluated by coating 1.5 mil thickness onto polyimide film and drying at 180°F (82°C) for 3 minutes. Laminates were formed by joining the coated polyimide film with copper foil under either a batch or continuous lamination process. For the batch lamination, the samples were cured in a hydraulic press at 350°F (177°C) for about 30-45 minutes. For the continuous lamination process the polyimide film is nipped to the copper foil using a calendar at 180°F (82°C) under minimal pressure and subsequently cured in an oven at either 250°F (121°C) or 300°F (149°C) without pressure. Several of the laminates were tested for peel strength as in Example VII. The results are given below.

Peel Strength (pounds/inch)

| Sample: | 1 | 2 | 3 | 4 | 5 | 6 | 7 | 8 | 9 | 10 | 11 | 12 |
|---|---|---|---|---|---|---|---|---|---|---|---|---|
| Batch Lamination | - | - | - | - | - | - | - | - | - | 11.0 | 10.5 | - |
| Continuous Lamination[a] | 10.5 | - | - | - | - | - | - | 9.6 | 9.8 | 11.0 | 9.0 | 10.7 |
| Continuous Lamination[b] | 9.9 | 9.5 | 9.4 | 10.6 | 10.5 | 11.5 | 9.0 | - | - | - | - | - |

[a] oven cured at 250°F (121°C) for 8 hours
[b] oven cured at 300°F (149°C) for 30 minutes

**Claims**

1. A process for making flexible electronic circuitry, comprising the use as a laminating adhesive of an aqueous dispersion of a modified water-insoluble latex polymer, wherein said polymer is prepared by the process comprising:

(a) preparing by emulsion polymerization an initial aqueous dispersion of an initial water-insoluble latex polymer of at least one ethylenically unsaturated monomer, wherein said ethylenically unsaturated monomer comprises 0 to two percent by weight, based on the total weight of said ethylenically unsaturated monomer, of multi-alpha, beta-ethylenically unsaturated monomer and wherein said initial water-insoluble latex polymer otherwise contains essentially no sites of ethylenic unsaturation,

(b) dispersing in said initial aqueous dispersion of initial water-insoluble latex polymer additional ethylenically unsaturated monomer comprising at least one monomer having at least two sites of alpha, beta-ethylenic unsaturation, whereby said additional monomer swells said initial latex polymer, and

(c) polymerizing said additional monomer within said monomer swollen initial latex polymer to form said modified water-insoluble latex polymer.

2. Process according to claim 1 wherein step (c) is not begun until after said initial latex polymer is swollen substantially to equilibrium with said additional monomer.

3. Process according to claim 1 or 2 wherein said initial latex polymer comprises from 70 to 95% by solid weight of said modified water-insoluble latex polymer.

4. Process according to claim 1 or 2 wherein said initial latex polymer comprises from 60 to 84 parts by weight $C_1$-$C_{12}$ alkyl acrylates or methacrylates, 0.1 to 6 parts by weight carboxylic acid monomer(s), and 15 to 40 parts acrylonitrile.

5. Process according to claim 4 wherein said carboxylic acid monomer is an acryloxy carboxylic acid.

6. Process according to any preceing claim wherein said additional ethylenically-unsaturated monomer comprises 25 to 100% by weight of monomer having at least two sites of alpha, beta-ethylenic unsaturation.

7. Process according to claim 6 wherein said additional ethylenically-unsaturated monomer comprises about 100% by weight 1,3-butyleneglycol dimethacrylate.

8. Process according to claim 6 wherein said additonal ethylenically-unsaturated monomer comprises about 75% by weight methyl methacrylate or isobornylmethacrylate and about 25% by weight 1,3-butyleneglycol dimethacrylate.

9. Process according to any preceding claim wherein said aqueous dispersion contains up to 10% by weight, based on polymer solids, of epoxy resin, difunctional amines or mixtures thereof.